# EUROPÄISCHE PATENTANMELDUNG

(11) **EP 1 767 849 A1**
(43) Veröffentlichungstag der Anmeldung: **28.03.2007**
(21) Anmeldenummer: 05020847.9
(22) Anmeldetag: 23.09.2005
(51) Int. Cl.: F21V 19/00

(54) **Leuchteinrichtung**

(71) Anmelder: Alcan Technology & Management Ltd., 8212 Neuhausen am Rheinfall (CH)
(72) Erfinder: Fuchs, Roman, 8212 Neuhausen am Rheinfall (CH); Werner, Martin, 78224 Singen (DE)

(57) **Zusammenfassung**

Die Erfindung betrifft eine Leuchteinrichtung (101, 111), enthaltend ein Lichtleitelement (102, 112) sowie dem Lichtleitelement (102, 112) zugeordnete Lichterzeugungsmittel. Die Leuchteinrichtung (101, 111) zeichnet sich dadurch aus, dass die Lichterzeugungsmittel eine Mehrzahl von Lichterzeugungselemente (104) mit jeweils einer Lichtquelle (105, 115) umfassen und das Lichtleitelement (102, 112) eine Mehrzahl von konkaven Vertiefungen (106, 116) aufweist, in welchen jeweils eine Lichtquelle (105, 115) eines Lichterzeugungselementes (104) angeordnet ist.

## Beschreibung

Vorliegende Erfindung betrifft eine Leuchteinrichtung, enthaltend ein Lichtleitelement sowie dem Lichtleitelement zugeordnete Lichterzeugungsmittel. Ferner betrifft die Erfindung ein Verfahren zur Herstellung einer Leuchteinrichtung.

Leuchtdioden, auch LED genannt, sind kleine punktförmige Halbleiterelemente, welche farbiges oder weisses Licht abgeben. LED's sind schon seit längerer Zeit bekannt und haben sich bsp. als farbige Lichtquellen für optische Signale bewährt. In den letzten Jahren ist die Bedeutung von LED's als Beleuchtungsquellen in der Lichttechnik erheblich gestiegen. Dies rührt einerseits daher, dass die Preise für LED's in den vergangenen Jahren kontinuierlich gesunken sind, so dass diese mittlerweile auch für konventionelle Lichtquellen anstelle von Glühlampen oder Leuchtstoffröhren wirtschaftlich eingesetzt werden können. Andererseits ist man heute in der Lage, mit vertretbarem Aufwand LED's herzustellen, welche das für Beleuchtungszwecke notwendige, weisse Licht erzeugen.

Die Kleinheit und punktförmige Strahlungscharakteristik der LED's hat beispielsweise bereits die Glühlampen im Automobilbereich, z.B. in der Innenbeleuchtung oder bei Bremslichtern, weitgehend ersetzt. Im Effektbereich, z. B. in der Werbung als Textlaufbänder, haben sich LED's schon seit langem durchgesetzt, da ihre Stärken in der Ausstrahlung von farbigem Licht liegen, welches mit vergleichsweise kurzen Ansprechzeiten abgegeben werden kann.

In Bezug auf den Wirkungsgrad sind LED's mit den herkömmlichen Glühlampen mittlerweile ebenbürtig. Im weiteren erreicht die neue Generation von LED's mittlerweile eine Leistung von rund 0,5 -2 Watt, welche den Einsatz von LED's in der funktionellen Beleuchtung interessant macht. Hinsichtlich der weiteren Entwicklung der LED-Technologie wird allgemein eine weitere Steigerung des Wirkungsgrades sowie, dank hochentwickelter Massenproduktion, ein weiteres Sinken der Preise erwartet. Der LED Technologie wird daher ein hohes Marktpotential für die Zukunft vorausgesagt.

Was den Einsatz von LED's in der funktionellen Beleuchtung betrifft, so weisen diese den Nachteil auf, dass ihr Licht in einem Halbraum in allen Richtungen von der Lichtquelle abgestrahlt wird. Für die Nutzung als Beleuchtung, insbesondere bei Bildschirmarbeitsplätzen führt dies zu Blendung. Desweiteren wird das Licht zu wenig effizient und zielgerichtet auf die Arbeitsplatzfläche gelenkt, sondern wird ungenutzt in den Raum abgestrahlt.

Ferner produzieren die LED's auf kleinstem Raum viel Wärme, welche abgeführt werden muss. Da die Lebensdauer der LED's sehr stark von ihrer Betriebstemperatur abhängt, ist eine effiziente Abfuhr der Wärme für einen wirtschaftlichen Betrieb von LED-Leuchten äusserst wichtig.

Überdies müssen für eine ausreichende Beleuchtung, z. B. in Räumen, mehrere LED's sinnvoll zu einer Einheit angeordnet und elektrisch angeschlossen werden. Dass neben den genannten Anforderungen auch noch das Design ansprechend sein soll, versteht sich von selbst.

Im Stand der Technik sind Lösungen bekannt, welche die Lichtführung optimieren, indem relativ teure Kunststofflinsen über die Lichtquellen gestülpt werden. Da die Kunststofflinsen in der Regel gute Wärmeisolatoren sind, führt diese Lösung zu Problemen mit der Wärmeabfuhr und so zu einer reduzierten Lebensdauer der LED's.

Der Erfindung liegt deshalb die Aufgabe zugrunde, eine Leuchteinrichtung mit einer Mehrzahl von Lichterzeugungselementen sowie einer Lichtleitstruktur zur Blendungsbegrenzung und optimierter Lichtführung vorzuschlagen, welche sich durch eine optimale Wärmeabfuhr, durch eine hohe Gestaltungsfreiheit und durch eine einfache und vergleichsweise kostentgünstige Fertigung auszeichnet.

Erfindungsgemäss wird die Aufgabe dadurch gelöst, dass die Lichterzeugungsmittel eine Mehrzahl von Lichterzeugungselemente mit jeweils einer Lichtquelle umfassen und das Lichtleitelement eine Mehrzahl von konkaven Vertiefungen mit einer reflektierenden Oberfläche aufweist, in welchen jeweils eine Lichtquelle eines Lichterzeugungselementes angeordnet ist.

Das Lichtleitelement sowie ggf. das Trägerelement sind bevorzugt flächenförmige Bauteile. Die Lichterzeugungselemente sind bevorzugt vom Funktionsprinzip her aus dem Stand der Technik bekannte Leuchtdioden (LED).

In einer ersten Basisausführung (A) der Erfindung sind die Lichterzeugungselemente mit ihren Lichtquellen in den Vertiefungen des Lichtleitelementes angeordnet. Die Lichterzeugungselemente können hierzu auf das Lichtleitelement geklebt sein. Die Stromzu- und Stromableitungen können z. B. auf der der Lichtemission abgewandten Rückseite des Lichtleitelementes aufgebracht sein, wobei die besagten Leitungen Teil eines Schichtsystems auf dem Lichtleitelement oder (z. B. als einzelne Leiterbahnen oder in Folienform) auf die Rückseite des Lichtleitelementes aufgeklebt sein können. Sind die Stromzu- und Stromableitungen auf der Rückseite des Lichtleitelementes aufgebracht, so werden diese zweckmässig durch Öffnungen im Lichtleitelement zu den Lichterzeugungselementen geführt.

Im weiteren können die Stromzu- und Stromableitungen auch als leitende, voll- oder teilflächige Schichten in einem auf der Lichtemissionsseite des Lichtleitelements angeordneten Schichtsystem integriert sein. Die eine leitende Schicht in Funktion als Stromzu- und/oder Stromableitung kann eine über der Reflexionsoberfläche angeordnete, transparente Schicht, wie z. B. eine ITO (Indium-Tin Oxide) Schicht, sein. Eine weitere leitende Schicht kann die Reflexionsschicht selbst sein. Ferner können die Stromzu- und/oder Stromableitungen auch durch zwischen einem Trägerkörper (z. B. ein Metallblech) und einer metallischen Reflexionsschicht angeordneten voll- oder teilflächigen Schichten ausgebildet sein. Auch hier kann die Reflexionsschicht selbst als leitende Schicht dienen.

In einer zweiten Ausführung (B) der Erfindung ist das Lichtleitelement über einem Trägerelement angeordnet, wobei die Lichterzeugungselemente auf dem Trägerelement aufgebracht sind. Das Lichtleitelement enthält eine Mehrzahl von konkaven Vertiefungen mit Öffnungen, in welchen jeweils eine Lichtquelle eines Lichterzeugungselementes angeordnet ist.

Die nachfolgenden Ausführungen haben Gültigkeit sowohl für die oben beschriebene Ausführungsform (A), als auch für die Ausführungsform (B), sofern aus dem Inhalt nicht eindeutig hervorgeht, dass es sich um Ausführungsform (B) handeln muss.

Das Lichtleitelement ist bevorzugt aus einem Walzprodukt, insbesondere aus einem Blech. Das Lichtleitelement ist besonders bevorzugt aus einem gewalzten Metallband. Das Metallband weist z. B. eine Dicke von 0,05 mm oder mehr, vorzugsweise 0,1 mm oder mehr, insbesondere 0,3 mm oder mehr und von 1,5 mm oder weniger und vorzugsweise 0,7 mm oder weniger auf. Das Lichtleitelement ist bevorzugt aus einem Metall, wie Stahl, Aluminium oder einer Aluminiumlegierung, wie z.B. Aluminium mit einer Reinheit von 98,3% und höher. Bevorzugte Aluminium-Legierungen sind diejenigen der Klassen AA 1000, AA 3000 und AA 5000.

Wenigstens die konkaven Vertiefungen des Lichtleitelementes weisen eine reflektierende Oberfläche auf, welche bewirkt, dass von der Lichtquelle seitlich abgestrahltes Licht zur Hauptemissionsrichtung x hin abgelenkt bzw. reflektiert wird. In bevorzugter Weiterbildung der Erfindung weist das gesamte Lichtleitelement auf der Lichtemissionsseite eine reflektierende Oberfläche auf.

Die Reflexionsoberfläche wird entweder durch die Oberfläche des Walzproduktes selbst oder durch eine über der Oberfläche des Walzproduktes aufgebrachten Reflexionsschicht aus einem Metall ausgebildet.

Direkt oder indirekt über der Reflexionoberfläche ist bevorzugt eine abschliessende transparente Schutzschicht aufgebracht, welche die Oberfläche vor mechanischen oder chemischen Einflüssen schützt. Diese Schutzschicht kann eine anodisch erzeugte Oxidschicht mit einer Dicke von z. B. 10 bis 5000 nm, insbesondere von 30 nm bis 1000 nm sein. Die Schutzschicht kann auch ein organischer, organischanorganischer oder anorganischer Schutzlack sein, wie z. B. ein Sol-Gel-Lack aus einem Polysiloxan.

Wird die Reflexionsoberfläche des Lichtleitelementes durch die Oberfläche des Walzprodukts aus Aluminium oder einer Aluminiumlegierung ausgebildet, so kann die Oberfläche mechanisch und/oder chemisch geglänzt sein. Ein mechanisches Glänzen kann z. B. ein Polieren umfassen. Ein chemisches Glänzen kann z.B. durch ein chemisches oder elektrochemisches Verfahren oder durch einen alkalischen Beizprozess erfolgen. Das Glänzverfahren wird zweckmässig vor einem allfälligen Anodisieren bzw. Beschichten mit einem Schutzlack durchgeführt.

Die transparente Schutzschicht kann direkt über der Reflexionsoberfläche liegen. Ferner kann zwischen der Schutzschicht und der Reflexionsoberfläche ein reflexionserhöhendes Schichtsystem, mit einer oder mehreren, auf der Reflexionsoberfläche aufgebrachten, transparenten Schichten, angeordnet sein, wobei die Schutzschicht Teil des reflexionserhöhenden Schichtsystems sein kann.

Die reflektierende Oberfläche kann z. B. eine Rauhigkeit Ra von weniger als 0,1 µm, vorzugsweise von weniger als 0,05 µm und insbesondere von weniger als 0,02 µm aufweisen. Die Oberflächenrauhigkeit Ra ist definiert in wenigstens einer der DIN-Vorschriften 4761 bis 4768.

Die Oberfläche des Reflektorkörpers kann glatt oder strukturiert sein. Die Strukturierung kann z. B. über eine Walze mit entsprechendem Prägemuster erzeugt sein.

Die Oberfläche des Reflektorkörpers kann bezüglich Strukturierung oder Rauhigkeit derart beschaffen sein, dass eine gezielte Lichtführung stattfindet.

Wir die Reflexionsoberfläche durch eine über dem Walzprodukt angeordnete Metallschicht gebildet, so kann diese aus Aluminium, Silber, Gold, Chrom, Nickel, Kupfer oder aus Legierungen davon sein. Die Reflexionsschicht kann direkt oder indirekt auf die Oberfläche des Walzproduktes aufgebracht sein. Zwischen Reflexionsschicht und Walzprodukt kann z. B. eine Vorbehandlungsschicht und/oder eine Lackschicht zur Einebnung von möglichen Unebenheiten angeordnet sein. Die Lackschicht kann ein organischer, organisch-anorganisch oder anorganischer Lack, wie z. B. ein Sol Gel Lack sein. Die Vorbehandlungsschicht kann eine Anodisier-, Chromatier- oder Phosphatierschicht sein.

Die Dicke der Reflexionsschicht kann beispielsweise 10 bis 200 nm (Nanometer) betragen. Ferner kann auf den Reflektorkörper bzw. auf dessen Vorbehandlungsschicht zur Einebnung der Oberflächenrauhigkeit eine funktionelle Schicht in der Ausführung einer organischen oder anorganischen Sol-Gel-Schicht aufgebracht sein. Die Reflexionsschicht kommt hier in der Regel direkt, oder über eine Haftschicht, auf die funktionelle Schicht zu liegen. Die Beschaffenheit der funktionellen Schicht ist z.B. in der EP 918 236 A1 ausführlich beschrieben.

Über der Reflexionsschicht kann, wie bereits oben erwähnt, ein reflexionserhöhendes Schichtsystem, mit einer oder mehreren, auf der Reflexionsschicht aufgebrachten, transparenten Schichten, angeordnet sein.

Die Reflexionsschicht, einzelne oder sämtliche reflexionserhöhenden Schichten, und/oder die Schutzschicht können durch Gas- oder Dampfphasenabscheidung im Vakuum, (physical vapor deposition, PVD), durch thermische Verdampfung, durch Elektronenstrahlverdampfung, mit und ohne lonenunterstützung, durch Sputtern, insbesondere durch Magnetronsputtering, durch Plasmapolymerisation oder durch chemische Gasphasenabscheidung (chemical vapor deposition, CVD) mit und ohne Plasmaunterstützung auf das Walzprodukt oder auf eine auf diesem befindlichen Schicht, aufgebracht werden. Die Lackschicht wird bevorzugt mittels eines konventionellen Lackierverfahrens aufgebracht.

Sol-Gel-Lacke werden zweckmässig in Gel-Form auf den Reflektorkörper, bzw. auf die entsprechende Oberfläche, aufgetragen bzw. abgeschieden und anschliessend getrocknet bzw. gehärtet. Der Trocknungsprozess besteht darin, die im Sol-Gel-Lack verbleibenden Wasser und Alkohole auszutreiben, wodurch der Sol-Gel-Lack aushärtet und z. B. eine witterungsbeständige und korrosionsfeste Schutzschicht auf der Reflexionsoberfläche entsteht.

Eine Lackbeschichtung erfolgt zweckmässig in einem kontinuierlichen Verfahren, durch beispielsweise Aufpinseln, Aufwalzen, Schleudern, Spritzen Tauchen bzw. Tauchziehbeschichten. Besonders bevorzugte kontinuierliche Beschichtungsverfahren sind das Banddurchlaufverfahren oder Bandlackierungsverfahren, auch Coil-Coating-Verfahren genannt.

Die Schichtdicke des ausgehärteten Schutzlackes beträgt beispielsweise wenigstens 1 µm, vorzugsweise wenigstens 2 µm, und beispielsweise höchstens 40 µm, vorzugsweise höchstens 20 µm, insbesondere höchstens 10 µm, und vorteilhaft höchstens 6 µm.

Das Lichtleitelement einer Leuchteinrichtung kann ein- oder mehrstückig sein. Im letzteren Fall ist das Lichtleitelement aus mehreren Teilelementen zusammengesetzt

Die konkaven Vertiefungen des Lichtleitelements sind bevorzugt kalottenförmig. Die Vertiefungen erweitern sich bevorzugt zur Hauptemissionsrichtung (x) hin. Die Vertiefungen können kreisförmige, ellipsenförmige, oder polygonale (mehreckige) Grundflächen aufweisen. Die konkaven Vertiefungen weisen bevorzugt eine rotations-symmetrische Umrissform auf.

Die Anforderungen, die an die reflektierende Oberfläche und die Geometrie wenigstens der Vertiefungen des Lichtleitelementes, vorzugsweise der gesamten der Lichtemissionsseite zugewandten Oberfläche des Lichtleitelements gestellt werden, richten sich nach der Norm DIN 5035 - Teil 7 und DIN EN 12464-1, welche in der DIN 5035 enthalten ist. Diese Normen zielen auf die Verhinderung einer Blendung von Personen, die sich in dem mit der entsprechenden Leuchte beleuchtenden Raum aufhalten, ab. Dies ist insbesondere für Bildschirmarbeitsplätze wichtig. In der Norm wird beispielsweise ein möglichst nach unten gerichtetes Lichtverhalten gefordert, wobei in Abhängigkeit vom Abstrahlwinkel unterschiedliche Leuchtdichten zulässig sind.

Die Geometrie der die LED's aufnehmenden konkaven Vertiefungen der Leuchteinrichtung, insbesondere das Verhältnis Durchmesser / Tiefe, ist vorzugsweise dergestalt, dass die Leuchteinrichtung eine Rundumentblendung aufweist, welche die Vorgaben der Norm DIN 5035 Teil 7 bezüglich der Bildklasse I, vorzugsweise I und II und insbesondere aller Bildschirmklassen I, II und III erfüllt. So ist beispielsweise bei der Bildschirmklasse I eine Leuchtdichte von maximal 1000 cd (Candelar)/m² und für die Bildschirmklasse III eine Leuchtdichte von maximal 200 cd/m² zulässig.

In einer bevorzugten Ausführung der Leuchteinrichtung sind in sämtlichen konkaven Vertiefungen Lichtquellen angeordnet. In dieser Ausführung weisen alle Vertiefungen bevorzugt dieselbe geometrische Form auf. Es ist auch möglich, dass nur ein Teil der Vertiefungen jeweils eine Lichtquelle enthält. Die Vertiefungen ohne Lichtquellen dienen im Fall der Ausführung (B) als Abstand- bzw. Distanzhalter zum Trägerelement. Auf diese Weise wird ein gleichmässiger Abstand zwischen Lichtleitelement und Trägerelement und somit ein stabiler Verbund gewährleistet. Die Geometrie der Vertiefungen mit Lichtquellen kann gleich oder verschieden von der Geometrie der Vertiefungen ohne Lichtquellen sein.

Die Vertiefungen, in welchen eine Lichtquelle angeordnet ist, weisen bevorzugt alle dieselbe Geometrie auf. Ihre Geometrien können jedoch auch verschieden sein.

Im weiteren können in einer Vertiefung auch mehrere Lichtquellen angeordnet sein. So können in einer Vertiefung mehrere Lichterzeugungselemente mit jeweils einer Lichtquelle oder ein Lichterzeugungselement mit mehreren Lichtquellen angeordnet sein.

Das Lichtleitelement weist im flachen, unverformten Zustand auf seiner Lichtemisi sionsseite eine Gesamtreflexion von z. B. mehr als 80%, vorzugsweise mehr als 85%, insbesondere mehr als 90%, vorteilhaft mehr als 93% und besonders vorteilhaft von mehr als 97% gemäss DIN 5036 Teil 3 auf. Der Wirkungsgrad des umgeformten, mit Vertiefungen versehenen Lichtleitelementes kann vom vorgenannten Wirkungsgrad verschieden sein.

Das Lichtleitelement kann z. B. über eine Klebverbindung mit dem Trägerelement und/oder den Lichterzeugungselementen verbunden sein. Andere Verbindungtechniken, wie Löten oder Formschlussverbindungen, sind ebenfalls möglich. Die Lichterzeugungselemente können ebenfalls auf das Trägerelement aufgeklebt sein.

Das Trägerelement ist bevorzugt aus einem ein- oder mehrschichtigen, folienförmigen flexiblen Material. Das Trägerelement kann z. B. aus einer Metallfolie oder einem wenigstens eine Metallfolie oder Metallschicht enthaltenden Mehrschichtverbund bestehen. Der Mehrschichtverbund kann neben der Metallfolie bzw. Metallschicht eine oder mehrere Kunststoffschichten bzw. -folien aufweisen. Die Metallfolie bzw. Metallschicht zeichnet sich dadurch aus, dass sie in der Lage ist, die von den auf dem Trägerelement befestigten Lichterzeugungselementen erzeugte Wärme teilweise oder vollständig abzuführen.

Das Trägerelement enthält bevorzugt Leiterbahnen und leitfähige Kontaktflächen zur Versorgung der Lichterzeugungselemente mit Strom. Die Leiterbahnen können mittels eines konventionellen Druckverfahrens, wie Tiefdruck oder Digitaldruck, auf das Trägerelement aufgebracht sein. Hierzu wird bevorzugt ein leitfähiges Bedrukkungsmittel in Form einer Flüssigkeit, z. B. in einem Tiefdruckverfahren, oder in Form eines schmelzbaren Pulvers, z. B. in einem elektrophotographischen Verfahren, verwendet. Die Leiterbahnen und Kontaktflächen sind zweckmässig über eine dielektrische Schicht von der Metallfolie bzw. -schicht elektrisch isoliert.

Anstelle von Leiterbahnen kann das Trägerelement auch zwei oder mehrere leitende, z. B. metallische Schichten enthalten, die über Zwischenschichten aus z. B. Kunststoff oder Papier gegeneinander elektrisch isolierend getrennt sind. Die leitenden Schichten können der Stromzu- und Stromableitung dienen. Das Lichterzeugungselement kann hierzu über ein oder mehrere das Trägerelement durchstossende Kontaktelemente mit den leitenden Schichten elektrisch verbunden sein.

Nachfolgend wird ein besonders bevorzugtes flächiges Trägerelement beschrieben, auf welchem lichtemittierende Lichterzeugungselemente, nachfolgend auch Beleuchtungselemente genannt, angeordnet sind, die zur Stromversorgung mit Stromzu- und Stromableitungen verbunden sind. Das Trägerelement enthält eine metallische Folie, die mit einer elektrisch isolierenden Schicht, nachfolgend der Einfachheit halber nur isolierenden Schicht genannt, bedeckt ist, auf der jeweils zwischen den Stromzu- und Stromableitungen Reihenschaltungen aus jeweils einem Beleuchtungselement und einer Vorwiderstandsfläche angeordnet sind, wobei jeweils ein Beleuchtungselement und eine Vorwiderstandsfläche einer Reihenschaltung sowie die Reihenschaltungen und die Stromzu- und Stromableitungen über Leiterbahnen miteinander verbunden sind.

Zwischen den Stromzu- und Stromableitungen sind nebeneinander bevorzugt mehrere Reihenschaltungen bzw. mehrere Zweige angeordnet, die jeweils hintereinander mehrere Reihenschaltungen aus jeweils einem Beleuchtungselement und einer Vorwiderstandsfläche umfassen. Ferner können Potentialausgleichsleitungen vorgesehen sein, die jeweils die nebeneinander angeordenten Punkte der Leiterbahnen der Zweige miteinander verbinden, welche zwischen Reihenschaltungen aus jeweils einem Beleuchtungselement und einer Vorwiderstandsfläche angeordnet sind.

Das mit Beleuchtungselementen bestückte Trägerelement kann in Form eines Dekkenelementes oder eines Lichtpaneels zu einer erfindungsgemässen Leuchteinrichtung weiterverarbeitet werden. Die einzelnen Beleuchtungselemente sind so angeordnet, dass eine gute Wärmeübertragung bzw. Ableitung in die als Träger dienende metallische Trägerfolie oder -schicht erfolgt. Auf diese Weise können die einzelnen Beleuchtungselemente je nach ihrer Anzahl mit einer Betriebsspannung von z. B. 20 V betrieben werden. Damit liegt die Betriebsspannung im Bereich von Kleinspannungen gemäss den VDE-Normen. Der Isolationsaufwand wird daher vorteilhafter Weise gering gehalten.

Die Leiterbahnen, die Stromzu- und Stromableitungen, die Anschlusskontaktflächen und/oder ggf. die Potentialausgleichsleitungen werden bevorzugt in einem Druckverfahren, insbesondere in einem Tiefdruckverfahren oder elektrophotographischen Druckverfahren, ein- oder mehrschichtig auf die Oberfläche der isolierenden Schicht aufgedruckt. Dazu wird vorzugsweise eine Leitfarbe, z.B. eine Silberleitfarbe, verwendet.

Auch die Vorwiderstandflächen können in einem Druckverfahren, insbesondere in einem Tiefdruckverfahren oder elektrophotographischen Druckverfahren, ein- oder mehrschichtig auf die Oberfläche der isolierenden Schicht aufgedruckt werden. Die Vorwiderstandflächen und die Leiterbahnen können sich überlappend aufgedruckt sein. Die Vorwiderstandsflächen sind bevorzugt aus einer Leitfarbe, vorzugsweise aus einer Grafitleitfarbe.

Die isolierende Schicht ist bevorzugt eine Lackschicht, wie z.B. Polyurethan. Die Lackschicht kann eine Dicke von 2 bis 50 µm, vorzugsweise 5 bis 20 µm aufweisen. Die Trägerfolie wird bevorzugt flächig mit der isolierenden Schicht versehen. Es ist denkbar, dass die isolierende Lackschicht zwei- oder mehrschichtig aufgetragen wird, um Isolationsfehler durch Löcher zu verhindern. Die Lackschicht wird bevorzugt mittels eines konventionellen Lackierverfahrens aufgebracht.

Die Lackbeschichtung erfolgt zweckmässig in einem kontinuierlichen Verfahren, durch beispielsweise Aufpinseln, Aufwalzen, Schleudern, Spritzen Tauchen bzw. Tauchziehbeschichten. Besonders bevorzugte kontinuierliche Beschichtungsverfahren sind das Banddurchlaufverfahren oder Bandlackierungsverfahren, auch Coil-Coating-Verfahren genannt. Es ist auch denkbar, dass die isolierende Schicht ebenfalls in einem Druckverfahren, wie Tiefdruck oder Elektrophotographiedruck, aufgetragen wird.

Es ist überdies möglich, die Isolation durch eine auf die Aluminiumfolie aufkaschierte Papierbahn oder Kunststofffolie zu erreichen.

Die Anschlüsse der lichtemittierenden Beleuchtungselemente werden vorzugsweise mit einem Leitkleber, vorzugsweise einem silberhaltigen Leitkleber, an den an Leiterbahnen angeordneten Anschlusskontaktflächen verklebt, oder an diesen verlötet. Der genannte silberhaltige Leitkleber garantiert eine gute Wärmeableitung aus den lichtemittierenden Beleuchtungselementen zur metallischen Trägerfolie. Die Anschlusskontaktflächen werden bevorzugt zusammen mit den entsprechenden Leiterbahnen in einem Tiefdruckverfahren aufgedruckt.

Bei einer bevorzugten Ausgestaltung der Erfindung als Lichttapete werden jeweils parallele Zweige mit vier oder mehr in Reihe geschalteten Reihenschaltungen aus jeweils einem lichtemittierenden Beleuchtungselement und einem Vorwiderstand zur Kompensation der unterschiedlichen Durchlasskennlinien der Beleuchtungselemente zwischen den Stromzu- und Stromableitungen angeordnet.

Die einzelnen lichtemittierenden Beleuchtungselemente werden nach ihrer Befestigung an den entsprechenden Anschlusskontaktflächen in vorteilhafter Weise durch eine Stabilisierungsbeschichtung weiter fixiert und mechanisch stabilisiert. Die Stabilisierungsbeschichtung bedeckt bevorzugt die Bereiche der Anschlüsse der Beleuchtungselemente und der Anschlusskontaktflächen, jedoch nicht die lichtabgebende Vorderseite der Beleuchtungselemente.

Da die Oberfläche der metallischen Trägerfolie praktisch ohne Zusatzkosten mit Leiterbahnstrukturen im Tiefdruckverfahren belegt werden kann, werden bei einer bevorzugten Ausgestaltung der Erfindung vorteilhafter Weise zusätzliche Leiterbahnen zum Potentialausgleich parallel zu den Stromzu- und Stromableitungen mitgedruckt. Normalerweise fliesst durch diese Potentialausgleichsleiterbahnen kein Strom, da alle lichtemittierenden Beleuchtungselemente, die zwischen einer Stromzuleitung und einer Stromableitung in Reihe geschaltet sind, auf gleichem Potential liegen. Fällt ein lichtemittierendes Beleuchtungselement aus, so fliesst ein Querstrom, der die mit dem ausgefallenen lichtemittierenden Beleuchtungselement in Reihe geschalteten lichtemittierenden Beleuchtungselemente weiterhin mit Strom versorgt. Dadurch fällt vorteilhafter Weise nicht die gesamte Reihe der lichtemittierenden Beleuchtungselemente, sondern nur ein lichtemittierendes Beleuchtungselement aus.

Ein wesentlicher Vorteil des erfindungsgemässen Verfahrens besteht auch darin, dass wegen der Aufbringung der Leiterbahnen, der Stromzuleitungen, der Stromableitungen, der Anschlusskontaktflächen, ggf. der Potentialausgleichsleiterbahnen sowie der Vorwiderstandsflächen durch das Tiefdruckverfahren im Vergleich zu Verfahren mit geätzten Leiterplatten oder mit im Siebdruck hergestellten Leiterplatten wesentlich kostengünstiger gearbeitet werden kann.

Die metallische Trägerfolie ist bevorzugt eine Aluminiumfolie, insbesondere eine hart gewalzte Alumininiumfolie, mit welcher die nötige Wärmeverteilung erreicht wird, um die punktförmig erzeugte Wärme der lichtemittierenden Beleuchtungselemente in die Fläche an der Rückseite der Aluminiumfolie abzuleiten und zu verteilen. Die metallische Trägerfolie kann eine Dicke von 10 bis 500 µm, insbesondere von 20 bis 200 µm aufweisen.

Das Körperteil eines fixierten Beleuchtungselementes sitzt bevorzugt auf einer darunter befindlichen Kontaktanschlussfläche, so dass eine gute Wärmeableitung vom Körperteil zur metallischen Trägerfolie erfolgt. Es ist auch denkbar, dass das Trägerelement im Bereich der Kontaktanschlussfläche keine isolierende Schicht enthält und das Körperteil direkt oder indirekt über eine Kontaktanschlussfläche mit der metallischen Folie verbunden ist.

Bei einer weiteren bevorzugten Ausgestaltung der Erfindung wird die flexible metallische Trägerfolie auf seiner den Beleuchtungselementen abgewandten Seite durch ein stabiles Verbundteil verstärkt, so dass selbsttragende Trägerelemente hergestellt werden können. Hierbei wird auf die metallische Trägerfolie ein vorzugsweise wabenförmig ausgestaltetes Verbundteil aus einem ebenfalls metallischen Material, insbesondere aus Aluminium oder einer Aluminiumlegierung, aufgeklebt, wobei die Gegenseite mit einem erfindungsgemässen Lichtverteiler abgedeckt wird. Dadurch werden die lichtemittierenden Beleuchtungselemente, Leiterbahnen und Widerstände vorteilhafter Weise mechanisch und elektrisch geschützt und es entsteht ein stabiles Sandwichelement mit wärmeableitender Rückseite und lichtabgebender Vorderseite, das mit anderen entsprechend ausgebildeten Sandwichelementen zur Schaffung grosser Leuchtflächen aneinander gereiht werden kann. Das Verbundteil kann hierbei ebenfalls als Wärmesenke dienen.

Über den leitfähigen Bahnen, Flächen bzw. Leitungen kann eine weitere elektrisch isolierende Schicht aufgebracht sein. Diese Schicht kann eine teilflächig oder grossflächig aufgebrachte Lackschicht aus einem Kunststoff oder eine Kunststoffolie sein. Die Lackschicht wird bevorzugt in einem konventionellen Lackierverfahren aufgetragen. Die Lackbeschichtung erfolgt zweckmässig in einem kontinuierlichen Verfahren, durch beispielsweise Aufpinseln, Aufwalzen, Schleudern, Spritzen Tauchen bzw. Tauchziehbeschichten. Besonders bevorzugte kontinuierliche Beschichtungsverfahren sind das Banddurchlaufverfahren oder Bandlackierungsverfahren, auch Coil-Coating-Verfahren genannt. Es ist auch denkbar, dass die isolierende Schicht ebenfalls in einem Druckverfahren, wie Tiefdruck oder Elektrophotographiedruck, aufgetragen wird.

Es ist möglich, das Lichtleitelement zusätzlich zur oder anstelle der metallischen Trägerfolie als Wärmesenke einzusetzen. Das Lichtleitelement stellt in einem solchen Fall eine wärmeleitende, d.h. wärmeschlüssige, Verbindung zum Beleuchtungselement, insbesondere zum Lichterzeugungselement, her. Anstelle einer metallischen Trägerfolie kann in einem solchen Fall auch eine Folie oder ein Laminat aus Kunststoff eingesetzt werden. Auf das Aufbringen einer isolierenden Schicht könnte in diesem Fall verzichtet werden.

Über dem Lichtleitelement kann in Weiterbildung der Erfindung eine Abdeckung angeordnet sein. Diese Abdeckung kann z. B. eine transparente Schutzabdeckung sein. Ferner kann die Abdeckung auch ein Lichtfilter sein. Die Abdeckung kann dem Lichtleitelement anliegen oder, z. B. über Distanzhalter, in Distanz zum Lichtleitelement angeordnet sein.

Die Leuchteinrichtung kann zur Innenbeleuchtung von Gebäuden, bzw. Räumen oder definierten Bereichen innerhalb von Gebäuden verwendet werden. Die Leuchteinrichtung kann auch zur flächendeckenden Aussenbeleuchtung oder eines definierten Bereichs davon eingesetzt werden. Die Leuchteinrichtung findet jedoch bevorzugt Einsatz als Arbeitsplatzleuchten, insbesondere als Bildschirmarbeitsplatzleuchten, zur blendungsfreien Beleuchtung einer definierten, begrenzten Arbeitsfläche. Ferner findet die erfindungsgemässe Leuchteinrichtung Verwendung im Automobilbau, z. B. zur Innenbeleuchtung oder in Form von Warn- oder Rücklichtern.

Innenleuchten können sein: Stehleuchten, Pendelleuchten, Wandleuchten, Bodenleuchten, Deckenleuchten, Tischleuchten, Einbauleuchten, Aufbauleuchten oder Systemleuchten. Aussenleuchten können sein: Wandleuchten oder Wegleuchten.

Ein bevorzugtes Verfahren zur Herstellung einer Leuchteinrichtung enthält folgende Schritte:
a) Herstellen eines bandförmigen Lichtleitelementes;
b) Formen von konkaven Vertiefungen in das Lichtleitelement;
c) Anbringen der Lichtquellen der Lichterzeugungselemente in den Vertiefungen.
   Diese Verfahrensschritte beziehen sich auf die Basisausführungen (A) und (B).
   Ein bevorzugtes Verfahren zur Herstellung der Basisausführung (B) sieht folgende Schritte vor:
   a) Herstellen eines bandförmigen Lichtleitelementes;
   b) Anbringen von Ausnehmungen im Lichtleitelement für die Lichtquellen;
   c) Formen von konkaven Vertiefungen im Bereich der Ausnehmungen im Lichtleitelement;
   d) Anordnen der Lichterzeugungselemente auf einem Trägerelement;
d) Zusammenführen des Lichtleitelements und des mit Lichterzeugungselementen bestückten Trägerelements, wobei die Lichtquellen durch die Ausnehmungen im Lichtleitelement hindurch in die konkaven Vertiefungen geführt werden.

Die Ausnehmungen werden bevorzugt vor der Ausformung der konkaven Vertiefungen ausgeführt. Es versteht sich, dass in Abwandlung des Verfahrens die Ausnehmungen auch nach Ausformung der Vertiefungen angebracht werden können. Die Ausnehmungen sind bevorzugt in den Vertiefungen zentriert angebracht.

Die konkaven Vertiefungen können in einem Tiefzieh- oder Streckziehprozess oder einem kombinierten Verfahren aus dem flächenförmigen Metallblech oder Metallband hergestellt werden. Die Ausnehmungen im Lichtleitelement werden bevorzugt mittels eines Stanzverfahrens angebracht.

Beschichtungen bzw. Beschichtungssysteme, wie Schutzschicht, reflexionserhöhende Schichten, ggf. eine Reflexionsschicht, werden bevorzugt vor dem Anbringen der Vertiefungen und Ausnehmungen auf das Band- bzw. Blechmaterial aufgebracht.

Im folgenden wird die Erfindung beispielhaft und mit Bezug auf die beiliegenden Zeichnungen näher erläutert. Es zeigen:
- Fig. 1:: Querschnitt durch eine erfindungsgemässe Leuchteinrichtung;
- Fig. 2a:: Draufsicht einer erfindungsgemässen Leuchteinrichtung;
- Fig. 2b:: perspektivische Ansicht einer erfindungsgemässen Leuchteinrichtung;
- Fig. 3:: einen Schnitt durch den Bereich eines lichtemittierenden Beleuchtungselementes auf einem Trägerelement;
- Fig. 4:: einen Schnitt durch den Bereich eines lichtemittierenden Beleuchtungselementes auf einem Trägerelement mit Verbundteil;
- Fig. 5:: eine Ansicht von oben auf ein mehrere lichtemittierende Beleuchtungselemente umfassendes flächenförmiges Trägerelement.

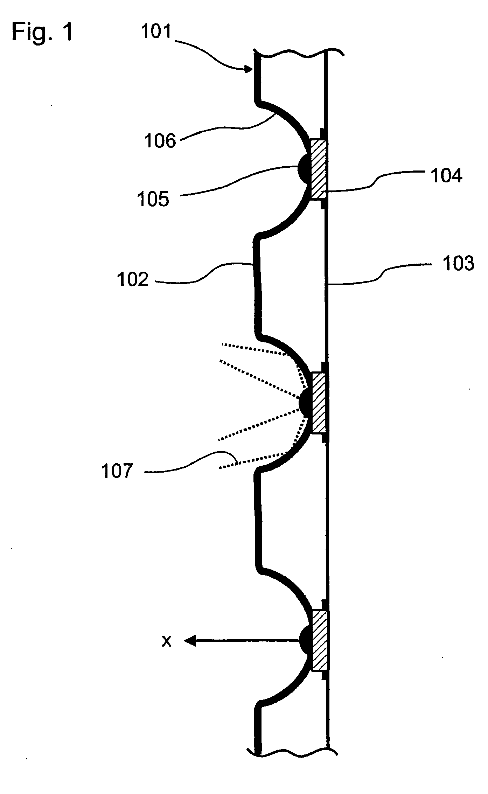

Figur 1 zeigt eine Ausführungform des Typs B einer erfindungsgemässen Leuchteinrichtung 101. Diese enthält ein flexibles Trägerelement 103, welches mit Leiterbahnen versehen ist, und auf welchem Lichterzeugungsmittel enthalten jeweils ein Lichterzeugungselement 104 und eine diesem zugeordnete Lichtquelle 105. Über dem Trägerelement 103 ist ein Lichtleitelement 102 angeordnet, welches eine Mehrzahl von kalottenförmigen Vertiefungen 106 enthält, wobei in den Vertiefung jeweils die Lichtquelle 105 des Lichterzeugungselementes 104 angeordnet ist. Wenigstens die kalottenförmigen Vertiefungen weisen eine reflektierende Oberfläche auf, welche bewirkt, dass seitlich abgestrahltes Licht zur Hauptemissionsrichtung x hin abgelenkt bzw. reflektiert wird.

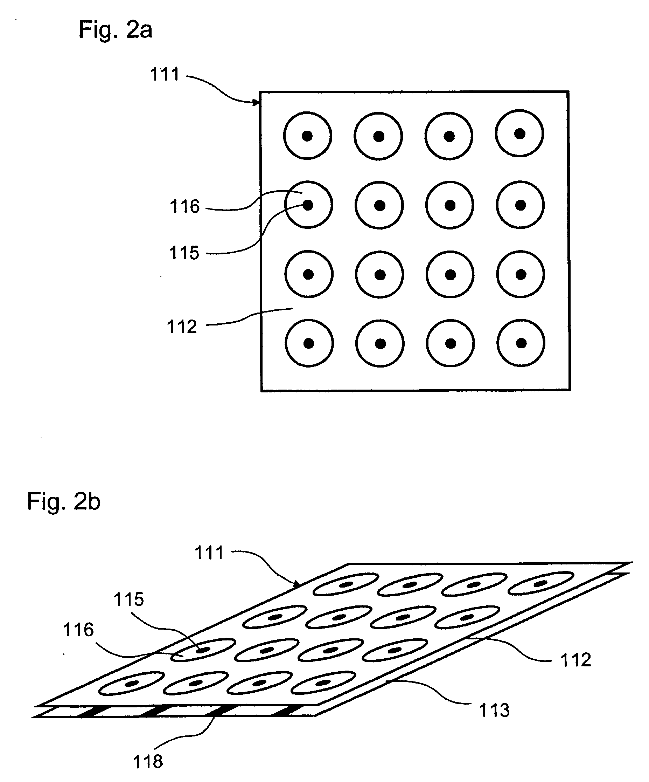

Die Figuren 2a und 2b zeigen eine erfindungsgemässe Leuchteinrichtung 111 mit einem Lichtleitelement 112, welches in Reihen angeordneten kalottenförmigen Vertiefungen 116 aufweist, in welchen jeweils eine Lichtquelle 115 eines Lichterzeugungselementes angeordnet ist. Die Lichterzeugungselemente sind auf einem, Leiterbahnen 118 aufweisenden Trägerelement 113 angeordnet.

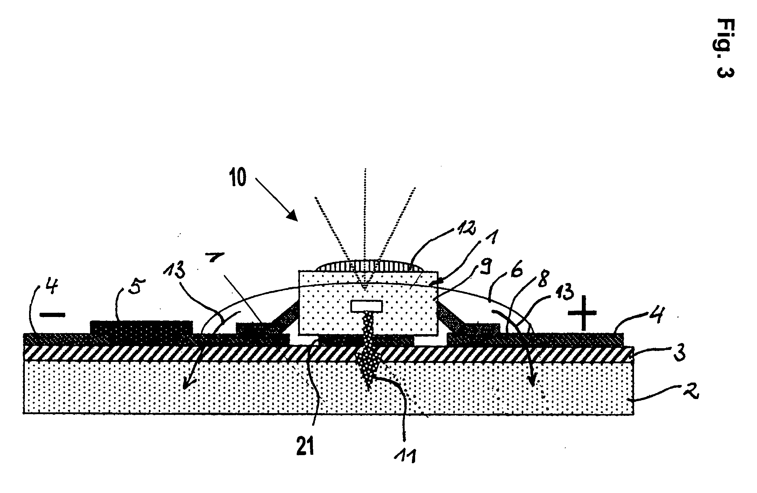

Die Figur 3 zeigt einen Schnitt durch den Bereich eines lichtemittierenden Beleuchtungselementes auf einem Trägerelement, vorzugsweise einer lichtemittierenden Diode. Das Beleuchtungselement besteht im wesentlichen aus einer metallischen Trägerfolie 2, vorzugsweise eine Aluminiumfolie, einer isolierenden Schicht 3, die vorzugsweise eine Lackschicht ist, Leiterbahnen 4, Anschlusskontaktflächen 8, 21, Vorwiderstandsflächen 5, lichtemittierenden Dioden (LED) 1 und einer Stabilisierungsbeschichtung 6. Bei der Ausführung des erfindungsgemässen Verfahrens wird zunächst auf die Aluminiumfolie 2, die vorzugsweise hart gewalzt ist und eine Dicke von etwa 70 µm besitzt, flächig eine isolierende Lackschicht 3 aufgetragen, die rund 10 µm dick ist.

Auf die Oberfläche der isolierenden Lackschicht 3 werden im Tiefdruckverfahren verschiedene elektrisch leitende Bahnen bzw. Flächen, die vorzugsweise aus Leitfarben bestehen und zur Herstellung der Stromzu- und Stromableitungen 4', der Leiterbahnen 4 zur Stromverteilung in die Fläche der Beleuchtungseinrichtung, der Anschlusskontaktflächen 8, 21 für die lichtemittierenden Dioden 1 sowie der Vorwiderstandsflächen 5 dienen, vorzugsweise mehrschichtig aufgedruckt. Die Stromzu- und Stromableitungen 4', die Leiterbahnen 4 sowie die Anschlusskontaktflächen 8, 21 bestehen besonders bevorzugt aus einer in einem Tiefdruckverfahrensschritt aufgedruckten Silberleitfarbe. Die Vorwiderstandsflächen 5 bestehen vorzugsweise aus einer in einem getrennten Tiefdruckverfahrensschritt aufgedruckten Grafitleitfarbe. Die Vorwiderstandsflächen 5 werden in dem getrennten Tiefdruckverfahrensschritt die entsprechenden Leiterbahnen 4 überlappend erzeugt, so dass gute elektrische Verbindungen entstehen.

Anschliessend werden die Anschlüsse 7 der lichtemittierenden Dioden 1 an den Anschlusskontaktflächen 8 der Leiterbahnen 4 befestigt. Zu diesem Zweck werden die Anschlüsse 7 bei einem Bestückvorgang in die richtige Lage in Bezug auf die Anschlusskontaktflächen 8 gebracht und mit der Hilfe eines Leitklebers an diesen befestigt bzw. verklebt, wobei eine gute elektrische Verbindung sowie eine Verbindung einer guten Warmeleitfähigkeit bewirkt werden. Alternativ können die Anschlüsse 7 der Dioden 1 auch an den Anschlusskontaktflächen 8 verlötet werden.

In der richtigen Lage sitzt das wärmeleitende Körperteil 9 der Dioden 1, das vorzugsweise aus Kupfer besteht, auf einer darunter befindlichen Anschlusskontaktfläche 21 auf, so dass in der Richtung des Pfeils 11 eine gute Wärmeableitung vom Körperteil 9 über die Leiterbahn 4 und die Lackschicht 3 zur Aluminiumfolie 2 erfolgt.

Die Anschlusskontaktflächen 8 können auch direkt durch einen Teilbereich der Leiterbahnen 4 gebildet werden.

Zur Stabilisierung und mechanischen Fixierung der Dioden 1 wird zweckmässigerweise eine Stabilisierungsbeschichtung 6 auf den Befestigungsbereich der Dioden 1 aufgebracht, wobei dafür Sorge getragen wird, dass die Dioden 1 jeweils nur soweit in das Material der Beschichtung 6 eingebettet werden, dass ihre lichtabgebende Vorderseite 12 frei liegt. Die Stabilisierungsbeschichtung 6 überdeckt gleichzeitig jeweils auch die Kontakte zwischen den Anschlüssen 7 der Dioden 1 und den entsprechenden Anschlusskontaktflächen 8. Die Aufbringung der stabilisierenden Beschichtung 6 ist besonders vorteilhaft, weil durch sie ein fester Verbund zwischen den Dioden 1 und der Aluminiumfolie 2 hergestellt wird, der gegenüber der an sich flexiblen Aluminiumfolie 2 starr ist.

Dadurch werden Biegeradien, die bei der Handhabung der Beleuchtungseinrichtung durch Verbiegungen entstehen, nicht direkt in die Kontaktstellen, sondern, wie dies durch die Pfeile 13 dargestellt ist, in die Aluminiumfolie 2 eingeleitet. Die Kontaktstellen werden dadurch wesentlich entlastet.

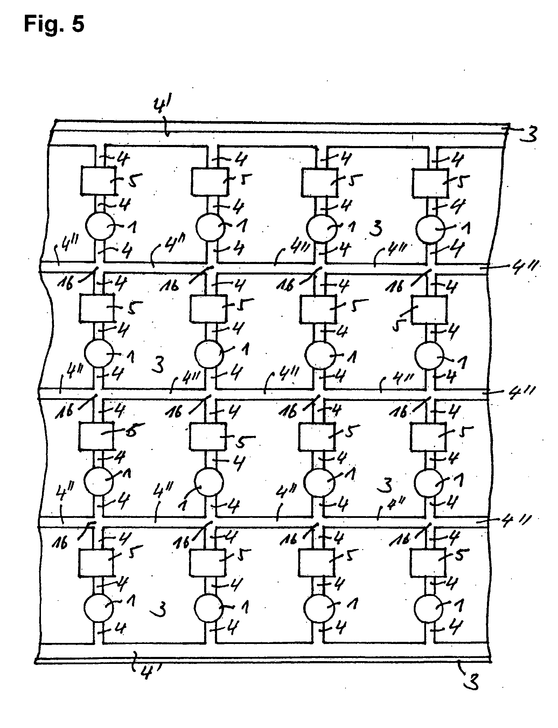

Gemäss der Figur 5 verlaufen zwischen den parallelen Stromzu- und Stromableitungen 4' nebeneinander angeordnet, parallele Zweige, die jeweils mehrere (z.B. vier) Reihenschaltungen aus jeweils einer Vorwiderstandsfläche 5 und einer Diode 1 in Reihe umfassen. Die Vorwiderstandsfläche 5 und die Diode 1 der Reihenschaltungen sind jeweils über eine Leiterbahn 4 miteinander verbunden. Die Reihenschaltungen eines Zweiges sind untereinander bzw. mit der Stromzu- und Stromableitung 4' ebenfalls über Leiterbahnen 4 verbunden.

Die in Richtung der Stromzu- und Stromableitungen 4' nebeneinander angeordneten Punkte 16 der Leiterbahnen 4 der Zweige, welche jeweils zwischen zwei sich entsprechenden Reihenschaltungen der Zweige liegen, können aus den eingangs erwähnten Gründen bevorzugt durch Potentialausgleichsleitungen 4" miteinander verbunden sein, die parallel zu den Stromzu- und Stromableitungen 4' verlaufen.

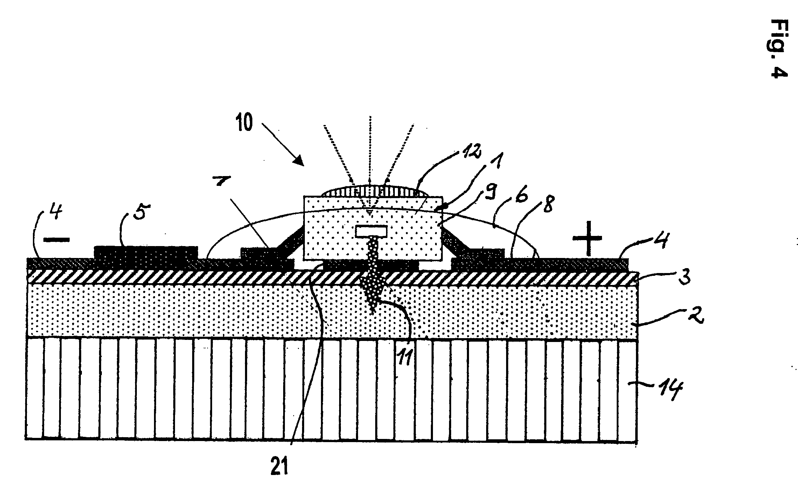

Zur Herstellung einer stabilen Beleuchtungseinrichtung, die als Leuchtpaneel gehandhabt werden kann, wird gemäss Figur 4 an der den Dioden 1 abgewandten Seite der Aluminiumfolie 2 ein vorzugsweise wabenförmig ausgestaltetes metallisches Verbundteil 14 befestigt, vorzugsweise verklebt, das zweckmässigerweise aus Aluminium besteht.

## Patentansprüche

1. Leuchteinrichtung (101, 111), enthaltend ein Lichtleitelement (102, 112) sowie dem Lichtleitelement (102, 112) zugeordnete Lichterzeugungsmittel,
**dadurch gekennzeichnet, dass**
die Lichterzeugungsmittel eine Mehrzahl von Lichterzeugungselementen (104) mit jeweils mindestens einer Lichtquelle (105, 115) umfassen und das Lichtleitelement (102, 112) eine Mehrzahl von konkaven Vertiefungen (106, 116) mit einer reflektierenden Oberfläche aufweist, in welchen jeweils mindestens eine Lichtquelle (105, 115) eines Lichterzeugungselementes (104) angeordnet ist.

2. Leuchteinrichtung nach Anspruch 1, **dadurch gekennzeichnet, dass** das Lichtleitelement (102, 112) über einem Trägerelement (103, 113) angeordnet ist, und die Lichterzeugungselemente (104) auf dem Trägerelement (103, 113) aufgebracht sind, und das Lichtleitelement (102, 112) eine Mehrzahl von konkaven Vertiefungen (6, 16) mit Öffnungen aufweist, in welchen jeweils eine Lichtquelle (105, 115) eines Lichterzeugungselementes (104) angeordnet ist.

3. Leuchteinrichtung nach einem der Ansprüche 1 bis 2, **dadurch gekennzeichnet, dass** die Lichterzeugungselemente (104) auf einem flächenförmigen Trägerelement aufgebracht und deren Lichtquellen (105, 115) jeweils in den konkaven Vertiefungen (106, 116) eines ebenfalls flächenförmigen Lichtleitelements (102, 112) angeordnet sind.

4. Leuchteinrichtung nach einem der Ansprüche 1 bis 3, **dadurch gekennzeichnet, dass** die Lichterzeugungselemente Leuchtdioden (LED) sind.

5. Leuchteinrichtung nach einem der Ansprüche 1 bis 4, **dadurch gekennzeichnet, dass** das Lichtleitelement ein Walzprodukt, insbesondere ein Blech, enthält oder im wesentlichen aus diesem besteht.

6. Leuchteinrichtung nach einem der Ansprüche 1 bis 5, **dadurch gekennzeichnet, dass** das Lichtleitelement ein gewalztes Metallband einer Dicke von 0,1 bis 1,5 mm, vorzugsweise von 0,3 bis 0,7 mm, enthält oder im wesentlichen aus diesem besteht.

7. Leuchteinrichtung nach einem der Ansprüche 5 bis 6, **dadurch gekennzeichnet, dass** das Walzprodukt aus Aluminium oder einer Aluminiumlegierung ist.

8. Leuchteinrichtung nach einem der Ansprüche 1 bis 7, **dadurch gekennzeichnet, dass** die konkaven Vertiefungen eine kreisförmige, ellipsenförmige, oder polygonale Grundfläche aufweisen.

9. Leuchteinrichtung nach einem der Ansprüche 1 bis 8, **dadurch gekennzeichnet, dass** die Geometrie der mit Lichtquellen ausgestatteten, konkaven Vertiefungen der Leuchteinrichtung dergestalt ist, dass die Leuchteinrichtung eine Rundumentblendung aufweist, welche die Vorgaben der Norm DIN 5035 Teil 7 bezüglich der Bildklasse I, vorzugsweise I und II und insbesondere aller Bildschirmklassen I, II und III erfüllen.

10. Leuchteinrichtung nach einem der Ansprüche 2 bis 9, **dadurch gekennzeichnet, dass** das Trägerelement (103, 113) aus einem ein- oder mehrschichtigen, folienförmigen Material besteht.

11. Leuchteinrichtung nach einem der Ansprüche 2 bis 10, **dadurch gekennzeichnet, dass** das Trägerelement (103, 113) Leiterbahnen (118) zur Versorgung der Lichterzeugungselemente (104) mit Strom enthält.

12. Leuchteinrichtung nach Anspruch 11, **dadurch gekennzeichnet, dass** die Leiterbahnen mittels eines Druckverfahrens, insbesondere Tiefdruck oder Digitaldruck, auf das Trägerelement aufgebracht sind.

13. Leuchteinrichtung nach einem der Ansprüche 2 bis 12, **dadurch gekennzeichnet, dass** das Trägerelement eine wärmeabführende Metallfolie (2) oder Metallschicht enthält, welche mit einer elektrisch isolierenden Schicht (3) bedeckt ist, auf welcher Leiterbahnen angeordnet sind.

14. Leuchteinrichtung nach einem der Ansprüche 2 bis 13, **dadurch gekennzeichnet, dass** das Trägerelement eine Metallfolie (2) enthält, welche mit einer elektrisch isolierenden Schicht (3) bedeckt ist, auf der jeweils zwischen Stromzu- und Stromableitungen (4') Reihenschaltungen aus jeweils einem Lichterzeugungselement (1) und einer Vorwiderstandsfläche (5) angeordnet sind, und dass jeweils ein Lichterzeugungselement (1) und eine Vorwiderstandsfläche (5) einer Reihenschaltung sowie die Reihenschaltungen und die Stromzu- und Stromableitungen (4') über Leiterbahnen (4) miteinander verbunden sind.

15. Verfahren zur Herstellung einer Leuchteinrichtung (101, 111) nach Anspruch 1, enthaltend folgende Schritte:
a) Herstellen eines bandförmigen Lichtleitelementes (102, 112);
b) Formen von konkaven Vertiefungen (106, 116) in das Lichtleitelement (102, 112);
c) Anbringen der Lichtquellen (105, 115) der Lichterzeugungselemente (102, 112) in den Vertiefungen (106, 116) des Lichtleitelements (102, 112).

16. Verfahren nach Anspruch 15, **gekennzeichnet, durch** folgende Schritte:
a) Herstellen eines bandförmigen Lichtleitelementes (102, 112);
b) Anbringen von Ausnehmungen im Lichtleitelement (102, 112) für die Lichtquellen (105, 115);
c) Formen von konkaven Vertiefungen (106, 116) im Bereich der Ausnehmungen im Lichtleitelement (102, 112);
d) Anordnen der Lichterzeugungselemente (104) auf einem Trägerelement (103, 113);
d) Zusammenführen des Lichtleitelements (102, 112) und des mit den Lichterzeugungselementen (104) bestückten Trägerelements (103, 113), wobei die Lichtquellen (105, 115) **durch** die Ausnehmungen im Lichtleitelement (102, 112) hindurch in die konkaven Vertiefungen (106, 116) geführt werden.

17. Verfahren nach einem der Ansprüche 15 bis 16, **dadurch gekennzeichnet, dass** die konkaven Vertiefungen in einem Streckziehprozess aus einem flächenförmigen Metallblech oder Metallband hergestellt werden.

18. Verfahren nach einem der Ansprüche 15 bis 17, **dadurch gekennzeichnet, dass** die Ausnehmungen im Lichtleitelement (102, 112) mittels eines Stanzverfahrens angebracht werden.

19. Verwendung der Leuchteinrichtung nach einem der Ansprüche 1 bis 14 für Arbeitsplatzleuchten.
